# EUROPEAN PATENT APPLICATION

(11) **EP 4 273 909 A2**
(43) Date of publication of application: **08.11.2023**
(21) Application number: 23170980.9
(22) Date of filing: 02.05.2023
(51) Int. Cl.: H01L 21/56, H01L 23/24, H01L 23/31, H01L 21/54, H01L 23/20

(54) **SEMICONDUCTOR MODULE WITH LIQUID DIELECTRIC ENCAPSULANT**

(30) Priority: 05.05.2022 US 202217737486
(71) Applicant: Infineon Technologies AG, 85579 Neubiberg (DE)
(72) Inventor: TROSKA, Georg, 58730 Fröndenberg (DE); HARTUNG, Hans, 59581 Warstein (DE)
(74) Representative: Lambsdorff & Lange Patentanwälte Partnerschaft mbB

(57) **Abstract**

A semiconductor module includes a power electronics carrier including a metallization layer disposed on an electrically insulating substrate, a power semiconductor die mounted on the power electronics carrier, a housing that surrounds an interior volume over the power electronics carrier, a volume of electrically insulating encapsulant that fills the interior volume and encapsulates the power semiconductor die, and a pressure compensation element disposed on or within the electrically insulating encapsulant, wherein the electrically insulating encapsulant is a liquid, wherein the semiconductor module forms an impermeable seal that contains the volume of electrically insulating encapsulant, and wherein the pressure compensation element is configured to maintain the electrically insulating encapsulant at a substantially constant pressure during thermal expansion and thermal contraction of the electrically insulating encapsulant.

## Description

### BACKGROUND

Many different applications such as automotive and industrial applications utilize power modules. Power modules may include multiple power devices in a single package, with these power devices being arranged as a power conversion circuit such as a single and multi-phase half-wave rectifier, single and multi-phase full-wave rectifier, voltage regulator, inverter, etc. Modern power modules are designed for highly efficient operation that can improve the electric power dissipation of an electrical system. In these applications, the power module can be subjected to harsh environmental conditions, e.g., substantial temperature variations, moisture, etc. Moreover, the power electronic circuitry contained within the power module including the semiconductor dies and associated passive elements generates a substantial amount of heat during operation. This creates challenges in providing an encapsulant that protects and electrically isolates the power electronic circuitry within the power module.

### SUMMARY

A semiconductor module comprises a power electronics carrier comprising a metallization layer disposed on an electrically insulating substrate; a power semiconductor die mounted on the power electronics carrier; a housing that surrounds an interior volume over the power electronics carrier; a volume of electrically insulating encapsulant that fills the interior volume and encapsulates the power semiconductor die; and a pressure compensation element disposed on or within the electrically insulating encapsulant, wherein the electrically insulating encapsulant is a liquid, wherein the semiconductor module forms an impermeable seal that contains the volume of electrically insulating encapsulant, and wherein the pressure compensation element is configured to maintain the electrically insulating encapsulant at a substantially constant pressure during thermal expansion and thermal contraction of the electrically insulating encapsulant.

A method of producing a semiconductor module comprises providing a power electronics carrier comprising a metallization layer disposed on an electrically insulating substrate; mounting a power semiconductor die on the power electronics carrier; providing a housing that surrounds an interior volume over the power electronics carrier; filling the interior volume with a liquid volume of electrically insulating encapsulant that encapsulates the power semiconductor die; forming an impermeable seal around the liquid volume of electrically insulating encapsulant; and providing a pressure compensation element on or within the electrically insulating encapsulant, wherein the pressure compensation element is configured to maintain the electrically insulating encapsulant at a substantially constant pressure during thermal expansion and thermal contraction of the electrically insulating encapsulant.

An electronics assembly comprises a plurality of semiconductor modules, each of the semiconductor modules comprising a power electronics carrier comprising a metallization layer disposed on an electrically insulating substrate, a power semiconductor die mounted on the power electronics carrier, and a liquid volume of electrically insulating encapsulant that encapsulates the power semiconductor die; and a pressure equalization system that is connected to each of the semiconductor modules, wherein the pressure equalization system is configured to equalize a pressure of the electrically insulating encapsulant from each of the semiconductor modules during thermal expansion and thermal contraction of the electrically insulating encapsulant.

Those skilled in the art will recognize additional features and advantages upon reading the following detailed description, and upon viewing the accompanying drawings.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
Figure 1 illustrates a semiconductor module with a liquid volume of electrically insulating encapsulant and a pressure compensation element, according to an embodiment.
Figure 2 illustrates a semiconductor module with a liquid volume of electrically insulating encapsulant and a pressure compensation element, according to another embodiment.
Figure 3 illustrates a semiconductor module with a liquid volume of electrically insulating encapsulant and a pressure compensation element, according to another embodiment.
Figure 4 illustrates a semiconductor module with a liquid volume of electrically insulating encapsulant and a pressure compensation element, according to another embodiment.
Figure 5 illustrates an electronics assembly with plurality of semiconductor modules each having a liquid volume of insulating encapsulant and a pressure equalization system that is connected to each of the semiconductor modules, according to an embodiment.

### DETAILED DESCRIPTION

Embodiments of a semiconductor module that comprises a liquid encapsulant are described herein. The liquid encapsulant protects the semiconductor devices and electrical interconnect elements of the semiconductor module and provides electrical dielectric isolation between these elements. The encapsulant can be an oil or synthetic liquid that remains as a stable liquid across the complete operational temperature range of the semiconductor module. A liquid encapsulant advantageously cannot crack or separate from the encapsulated elements, as can occur with a solid material. Moreover, a liquid encapsulant efficiently transfers heat away from localized hotspots. One challenge associated with using a liquid as a dielectric encapsulant is that the liquid must be prevented from leaking out of the module, while also being permitted to thermally expand and contract under across a range of temperatures. The semiconductor modules disclosed herein seal the liquid dielectric to prevent it from leaking and advantageously comprise pressure compensation features that permit the liquid dielectric to thermally expand and contract in an enclosed volume.

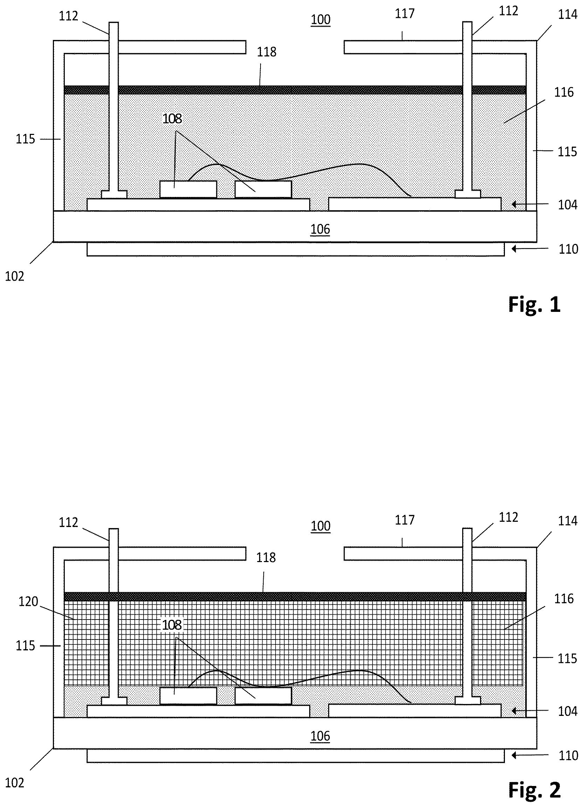

Referring to Figure 1, a semiconductor module 100 is depicted, according to an embodiment. The semiconductor module 100 comprises a carrier 102. The carrier 102 is a substrate that is configured to accommodate the mounting of multiple power semiconductor devices thereon and to efficiently extract heat away from these power semiconductor devices during operation. The carrier 102 comprises a structured metallization layer 104 disposed on an electrically insulating substrate 106. The structured metallization layer 104 comprises a plurality of pads that are disposed on the electrically insulating substrate 106 and are electrically isolated from one another. The pads are dimensioned to accommodate the mounting of semiconductor dies 108 or passive elements thereon. Additionally, the pads can form part of an electrical interconnect structure that connects two or more devices together. The carrier 102 may additionally comprise a second metallization layer 110 disposed on a rear side of the electronics carrier 102. The second metallization layer 110 may be a continuous layer that is used to thermally couple the semiconductor module 100 to a cooling apparatus, such as a heat sink.

According to an embodiment, the carrier 102 is a power electronics carrier, such as a Direct Copper Bonding (DCB) substrate, a Direct Aluminum Bonding (DAB) substrate, an Active Metal Brazing (AMB) substrate, or an Insulated Metal Substrate (IMS). In the case of a DCB substrate, DAB substrate, or AMB substrate, the electrically insulating substrate 106 may comprise a ceramic material such as Al₂O₃ (Alumina) AIN

(Aluminium Nitride), etc. In the case of an IMS substrate, the electrically insulating substrate 106 may comprise filled materials such as epoxy resin or polyimide. The circuit carrier 102 may also be a printed circuit board (PCB). In that case, the electrically insulating substrate 106 may comprise a resin material such as FR-4. In any of the above, the first structured metallization layer 104 and the second metallization layer 110 may comprise or be plated with any or more of Cu, Ni, Ag, Au, Pd, Pt, NiV, NiP, NiNiP, NiP/Pd, Ni/Au, NiP/Pd/Au, or NiP/Pd/AuAg.

The semiconductor module 100 comprises semiconductor dies 108 mounted on the carrier 102. According to an embodiment, at least one of semiconductor dies 108 is a power semiconductor die. A power semiconductor die refers to a single device that is rated to accommodate voltages of at least 100 V (volts) and may be on the order of 600 V, 1200 V or more and/or is rated to accommodate currents of at least 1A and may be on the order of 10A, 50A, 100A or more. Examples of power semiconductor dies include discrete power diodes and discrete power transistor dies, e.g., MOSFETs (Metal Oxide Semiconductor Field Effect Transistors), IGBTs (Insulated Gate Bipolar Transistors), and HEMTs (High Electron Mobility Transistors), etc. Separately or in combination, the semiconductor dies 108 mounted on the carrier 102 may comprise other types of devices, e.g., logic devices, custom circuits, controllers, sensing devices, passive elements, etc.

The semiconductor module 100 may be configured as a power converter or power inverter. For example, the semiconductor dies 108 may be power transistors that form the high-side switch and low-side switch of a half-bridge circuit. The power module may additionally comprise driver dies that control a switching operation of the half-bridge circuit. The power module may additionally include passive devices, e.g., capacitors, inductors, resistors, etc. Electrical interconnection between the various elements on the power electronics substrate 106 may be effectuated using metal interconnect elements, e.g., clips, ribbons, bond wires (as shown), etc., that are soldered to the devices and/or metal pads. Additionally, the semiconductor module 100 may comprise additional metal structures, such as tabs or busbar structures (not shown) that deliver fixed voltages to the various devices mounted on the on the carrier 102.

The semiconductor module 100 comprises a housing 114 that surrounds an interior volume over the carrier 102. In this context, the interior volume refers to a three-dimensional space that disposed over and around the enclosed surfaces of the carrier 102. In certain configurations, the housing may also surround a volume that is below portions of the carrier 102. Thus, the housing 114 in combination with the carrier 102 define a three-dimensional space. The housing 114 comprises outer sidewalls 115 and may comprise a roof section 117 that partially or completely encloses the interior volume. In other embodiments to be disclosed below, the housing 114 may work in combination with a lid structure that is placed on the housing to enclose an interior volume.

The semiconductor module 100 comprises terminal connectors 112 extending from the carrier 102 to a location that is externally accessible outside of the interior volume that is enclosed by the housing 114. The terminal connectors 112 may be formed from an electrically conductive metal, e.g., copper, aluminum, nickel, alloys thereof. The terminal connectors 112 may be attached to the structured metallization layer 104 and/or to other electronic components inside the module 100 by a conductive adhesive, e.g., solder, sinter, conductive glue, etc. The terminal connectors 112 may be adapted to mate with a particular receptacle, e.g., a PCB. The terminal connectors 112 may have a variety of geometric configurations different from what is shown.

In the depicted embodiment, the housing 114 is affixed directly to the carrier 102. Thus, the carrier 102 provides a floor section of the semiconductor module 100. In other embodiments, the housing 114 can be affixed to a separate metal baseplate, e.g., a planar baseplate comprising copper, aluminium, alloys thereof, etc. In that case, the carrier 102 can also be mounted on the metal baseplate and thermally coupled to the metal baseplate via the second metallization layer 110.

The semiconductor module 100 comprises a volume of electrically insulating encapsulant 116 that fills the interior volume and encapsulates the semiconductor dies 108. The encapsulant 116 encapsulates the components arranged inside the housing 114, e.g., the semiconductor dies 108 and associated electrical conditions, thereby protecting these elements from exterior environmental conditions and mechanical damage. Additionally, the encapsulant 116 is a dielectric material that electrically isolates these components from one another and from other potentials, such as a module baseplate. For example, the encapsulant 116 may have a dielectric strength of at least 16kV/mm and/or a a specific resistance of at least 2 * 10¹⁵ Ω·cm or at least 2.5 * 10¹⁵ Ω·cm.

The encapsulant 116 is introduced into the semiconductor module 100 as a liquid and remains as a liquid thereafter. This liquid property of the encapsulant 116 differs from a from a curable potting compound, such as a dielectric gel, which may be heated to a liquid or gelatinous state during the initial encapsulation process and subsequently cured into a hardened or quasi-hardened state, e.g., by cooling, drying, exposure to an external agent or any combination thereof. In this context, a liquid may encompass a material with a dynamic viscosity of between 0.5×10⁻³ Pa·S (Pascals per Second) and 50×10⁻³ Pa S across the operational temperatures of the semiconductor module. The encapsulant 116 may be introduced into the semiconductor module 100 as a liquid at room temperature (e.g., between about 20°-25°C (centigrade). The encapsulant 116 may be a stable liquid, meaning that the encapsulant 116 does not decompose or otherwise chemically react with the components of the semiconductor module 100, e.g., the semiconductor dies 108 and/or metal elements. The encapsulant 116 can retain the property of a stable liquid across all operational temperatures of the semiconductor module 100. The operational temperatures of the semiconductor module 100 can vary by application. The operational temperatures can be as low as -25°C, - 40°C, -50°C, -55°C or lower and can be as high as 150°C, 200°C, 250°C, 300°C or higher. In one example, the operational temperatures of the semiconductor module 100 are between -40°C and 200°C. Examples of an encapsulant 116 that satisfy the liquidity and stability requirements include oils such as silicon-based oils and petroleum-based oils such as transformer oil. The encapsulant 116 can also comprise synthetic materials such as Perfluoroalkyl and Polyfluoroalkyl based materials.

Advantages of a liquid encapsulant 116 in comparison to a solid encapsulation material include the following. A liquid encapsulant 116 does not crack or separate from the encapsulated elements due to its liquid state. A further benefit is the occurrence of Brownian motion in the liquid. This effect describes the continuous motion of particles in a liquid and is dependent on the temperature of the material. Due to the movement of particles, the creation of voids within the liquid is unlikely, and any voids that do form will dislocate immediately and will not cause permanent damage. Furthermore, Brownian motion will also allow the semiconductor module 100 to operate under higher temperatures. In power modules with solid encapsulation materials, the thermos-cycling of heat generating elements such as bond wires or semiconductor dies creates localized hotspots that limit the stability of the encapsulant. Due to Brownian motion a more uniform temperature distribution inside the module can be achieved.

The semiconductor module 100 is configured such that the volume liquid of encapsulant 116 is contained by an impermeable seal. An impermeable seal refers to an enclosure formed by surfaces from one or more structures that are impervious to the flow of liquid therethrough. The impermeable seal maintains the volume of liquid encapsulant within the housing 114 throughout the useful life of the semiconductor module. The impermeable seal may be arranged to completely contain the volume liquid of encapsulant 116 so that the semiconductor module 100 can be turned upside down and/or be rapidly accelerated or decelerated and/or be subject to thermal cycling without the liquid of encapsulant 116 leaking out of the interior volume. The housing 114 and the power electronics carrier or a baseplate (if present) may form part of the impermeable seal, as the material composition of these elements is impervious to liquid flow. Optionally, the impermeable seal may be substantially air-tight, meaning that no unwanted air pockets are present within the seal, e.g., from ambient atmosphere during the encapsulation process.

The impermeable seal of the semiconductor module 100 may require dedicated sealing steps and/or features that are not necessarily required in the case of a solid encapsulation material. For example, the interfaces between the housing 114 and the carrier 102 or a baseplate (if present) may be sealed by a liquid-resistant adhesive such as a glue or epoxy. Separately or in combination, the locations wherein the terminal connectors 112 protrude out from the impermeable seal may be sealed to prevent the liquid encapsulant 116 from escaping in these locations. These locations can be sealed by a liquid-resistant adhesive such as a glue or epoxy. Alternatively, the sealant layer to be described in further detail below can be arranged to coincide with the locations wherein the terminal connectors 112 protrude out from the impermeable seal by appropriately setting the fill level of the liquid encapsulant 116.

The semiconductor module 100 additionally comprises a sealant layer 118 on an upper surface of the liquid encapsulant 116 that is opposite from the carrier 102, and wherein the sealant layer 118 forms part of the impermeable seal. The sealant layer 118 extends completely between the sidewalls 115 of the semiconductor module 100 and thus confines the liquid encapsulant 116 within a region that is disposed below the sealant layer 118. The sealant layer 118 can comprise any material that is able to contain the liquid encapsulant 116 and withstand the movements of the semiconductor module 100 during operation. Examples of these materials includes silicones, epoxy materials, polymer materials, and rubber materials.

The interior volume of the semiconductor module 100 can be filled with the liquid encapsulant 116 in a variety of ways. For example, the semiconductor module 100 may comprise a channel (not shown) into the interior volume that liquid encapsulant 116 116 can be flowed through until the liquid encapsulant 116 reaches a predetermined fill level. The channel can be sealed by a valve or liquid-resistant adhesive such as a glue or epoxy after the filling to maintain the impermeable seal. According to another embodiment, a nozzle (not shown) could penetrate a pre-installed membrane (not shown) and introduce the liquid encapsulant 114 into the housing 116. According to another concept, after the housing 114 and carrier 102 or baseplate are sealed together, the three-dimensional volume can be submerged in a volume of liquid encapsulant 116. In this case a cleaning step can be performed to clean an outside of the housing 114.

The semiconductor module 100 comprises one or more pressure compensation elements that are disposed on or within the liquid encapsulant 116. The pressure compensation element is configured to maintain the electrically insulating liquid encapsulant 116 at a substantially constant pressure during thermal expansion and thermal contraction of the electrically insulating liquid encapsulant 116. As used herein, a substantially constant pressure refers to a pressure difference of no more than 10%. Forming a seal around the liquid encapsulant 116 presents a challenge with respect to thermal expansion. The above-mentioned materials for the liquid encapsulant 116 have a different CTE (coefficient of thermal expansion) as the elements in contact with the liquid encapsulant 116, e.g., the semiconductor dies 108, the carrier 102, the housing 114, etc. For instance, the liquid encapsulant 116 may have a CTE in the range of 200-500 × 10⁻⁶ m/K (Meters per Kelvin) whereas the elements in contact with the liquid encapsulant 116 may have a CTE that is at least 10 times lower. Thus, as the liquid encapsulant 116 reaches higher temperatures, e.g., 50°C, 100°C or more, the liquid encapsulant 116 expands at a greater rate than the elements in contact with the liquid encapsulant 116. If the liquid encapsulant 116 is rigidly sealed, pressure created by the volumetric expansion of the liquid encapsulant 116 may cause deformation of the housing, allowingf the liquid encapsulant 116 to leak out of the housing 114, and/or of entry of air into the housing 114 and liquid encapsulant 116. The pressure compensation element or elements are configured to maintain the electrically insulating liquid encapsulant 116 at a substantially constant pressure across the operational temperatures of the semiconductor module 100 by elastically deforming in response to the thermal expansion and thermal contraction of the liquid encapsulant 116. Stated another way, the pressure compensation element is configured to permit the volume of liquid encapsulant 116 to dynamically change in response to temperature variation, thereby preventing damaging levels of pressure from arising in the liquid encapsulant 116.

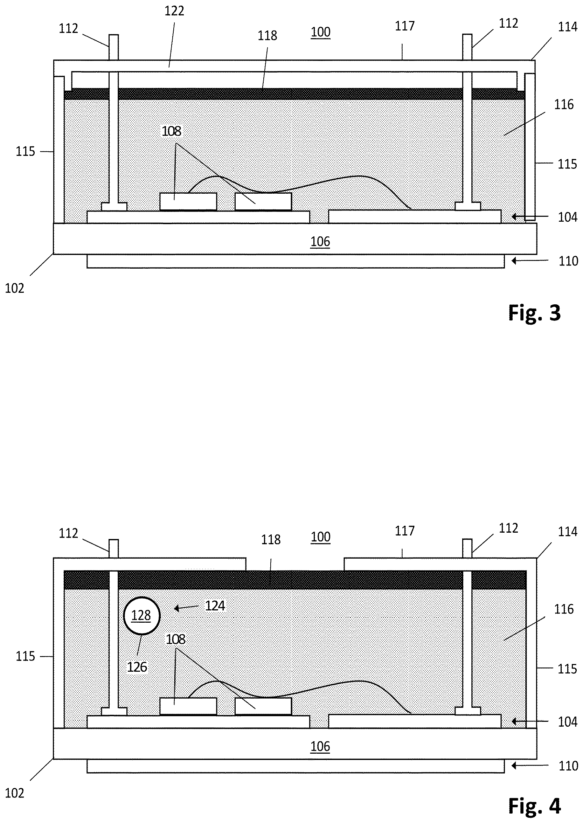

According to an embodiment, the pressure compensation element comprises an elastic element that is disposed on or within the liquid encapsulant 116. The elastic element may be from a surface that surrounds the liquid encapsulant 116 and forms the impermeable seal. Separately or in combination, the elastic element may be from a structure that is immersed within the volume of the liquid encapsulant 116, an example of which will be described in further detail below with reference to Figure 4. In either case, the elastic element is configured to maintain the electrically insulating liquid encapsulant 116 at the substantially constant pressure by elastically deforming in response to the thermal expansion and the thermal contraction. The elastic element may comprise an elastic material that is impervious to liquid and stable across all operational temperatures of the power material. Examples of these materials include polymers, silicon-based materials and rubbers such as TRITOFLEX^{™} 2K rubber.

According to an embodiment, the sealant layer 118 comprises an elastic membrane that forms at least part of the pressure compensation element. This elastic membrane is disposed on the upper surface of the liquid encapsulant 116 and extends between sidewalls 115 of the housing 114. This elastic membrane maintains the electrically insulating liquid encapsulant 116 at a substantially constant pressure under variation in temperatures by elastically expanding in response the thermal expansion of the liquid encapsulant 116 and elastically compressing in response the thermal contraction of the liquid encapsulant 116. A sealant layer 118 with an elastic membrane may be formed from a potted material that is formed on top of the liquid encapsulant 116 after the interior volume is filled with the liquid encapsulant 116. The material of the sealant layer 118 may have a specific density lower than the density of the liquid encapsulant 116. The sealant layer 118 can contact the housing 114 as well as the terminal connectors 112, thereby maintaining a liquid seal at the exit point of the terminal connectors 112. The potted material can be cured to change its state from liquid to elastic solid. This elastic membrane may membrane acts as inhibitor for noxious gases. Examples of material that can be used in this regard include silicon-based dielectric gels.

Referring to Figure 2, in another embodiment of the semiconductor module 100, a three-dimensional grid 120 of material is immersed within the volume of liquid encapsulant 116. Examples of three-dimensional grid 120 structures include foams, sponges, technical filters, and three-dimensional textiles. The three-dimensional grid 120 is formed from a material that is solid at room temperature. For example, the three-dimensional grid 120 can comprise a polymer or resin material. The three-dimensional grid 120 can be arranged in the interior volume before the dispensing of the liquid encapsulant 116. The three-dimensional grid 120 absorbs the liquid encapsulant 116 and thereby evenly distributes the liquid encapsulant 116 throughout the interior volume. Additionally, the three-dimensional grid 120 allows for easier formation of the sealant layer 118 on top of the liquid encapsulant 116. One challenge in forming and curing a sealant material such as a potting compound on top of the liquid encapsulant 116 is that the sealant material may fall into the liquid encapsulant 116. While it may be possible to obtain a leveling through the correct choice of specific masses of the materials and waiting time, the three-dimensional grid 120 can minimize material exchange between the sealant material and the liquid encapsulant 116 and hence allow easier formation of a seal.

Referring to Figure 3, in another embodiment of the semiconductor module 100, the sealant layer 118 can be attached to a lid 122. That is, instead of forming the sealant layer 118 on top of the liquid encapsulant 116 after dispensing the liquid encapsulant 116 as in the previous embodiments, the semiconductor module 100 comprises a sealant layer 118 that is an elastic solid 122 as part of the lid 122 structure. The remaining part of the lid 122 can be formed from the same material as the housing 114, e.g., plastic. The lid 122 is dimensioned to be arranged on the sidewalls 115 of the housing 114 and enclose the interior volume. The lid 122 thus forms an exterior cover over the interior volume that rests on the sidewalls 115 of the housing 114. The sealant layer 118 faces the interior volume of the semiconductor module 100 and contacts the liquid encapsulant 116 when the lid 122 is securely affixed to the housing 114, thereby forming the impermeable seal and providing at least part of the pressure compensation element.

Referring to Figure 4, in another embodiment of the semiconductor module 100, the sealant layer 118 is a rigid layer that is part of the housing 114. The sealant layer 118 can be a molded layer of epoxy or rubber such as TRITOFLEX^{™} 2K rubber, for example. In a difference to the previous embodiments, the sealant layer 118 does not comprise an elastic membrane and thus provides little to no pressure relief for the the liquid encapsulant 116. However, the sealant layer 118 forms part of the impermeable seal in a similar manner as described above.

The pressure compensation element from the embodiment of Figure 4 comprises at least one sealed bubble 124 that is immersed within the electrically insulating liquid encapsulant 116. The sealed bubble 124 comprises an elastic membrane 126 and a gaseous volume 128 contained within the elastic membrane 126. The elastic membrane 126 can comprise any of the above-mentioned materials used for the elastic membrane 126 of the sealant layer 118, e.g., silicones, epoxy materials, polymer materials, and rubber materials. The gaseous volume 128 can comprise any gas that is stable across the operating temperatures of the semiconductor module 100, including ambient atmosphere and other non-volatile gasses.

The sealed bubble 124 maintains the electrically insulating liquid encapsulant 116 at a substantially constant pressure by compressing in response to the thermal expansion of the liquid encapsulant 116 and expanding in response to the thermal contraction of the liquid encapsulant 116. That is, the gaseous volume 128 inside the sealed bubble 124 in combination with the elastic membrane 126 permits expansion and contraction of the sealed bubble 124 in counter-correlation with the expansion and contraction the liquid encapsulant 116. The sealed bubble 124 therefore can be used in combination with a rigid sealing layer to maintain the pressure of the liquid encapsulant 116. The sealed bubble 124 can also be used in other embodiments as a supplemental part of the pressure compensation element. The sealed bubble 124 can be affixed to a stable element within the interior volume, such as a sidewall of the housing 114 or a dedicated post structure, to maintain the sealed bubble 124 immersed within the electrically insulating liquid encapsulant 116.

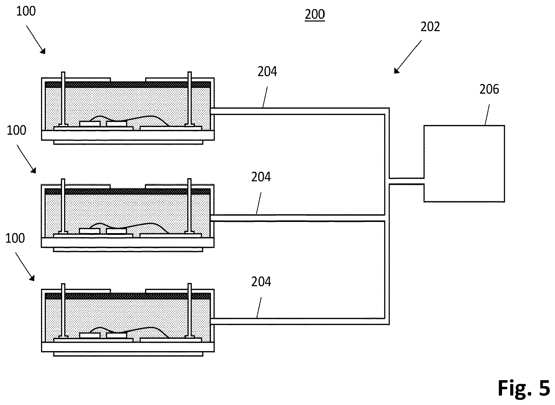

Referring to Figure 5, an electronics assembly 200 is depicted, according to an embodiment. The electronics assembly 200 comprises a plurality of the semiconductor modules 100. As shown, the electronics assembly 200 comprises three of the semiconductor modules 100. In principle, this concept can be utilized with any plurality of the semiconductor modules 100, e.g., two, three, four, etc. The electronics assembly 200 comprises a pressure equalization system 202 that is connected to each of the semiconductor modules 100. The pressure equalization system 202 is configured to equalize a pressure of the electrically insulating liquid encapsulant 116 from each of the semiconductor modules 100 during thermal expansion and thermal contraction of the electrically insulating liquid encapsulant 116. This centralized pressure equalization system 202 may supplement or replace the pressure compensation elements for individual semiconductor modules 100. The pressure equalization system may also be used to create uniform pressure across the multiple semiconductor modules.

As shown, the pressure equalization system 202 comprises piping 204 that is connected to the interior volume of each of the semiconductor modules 100. The piping from each of the semiconductor modules 100 connects with a centralized expansion unit 206. The centralized expansion unit 206 accommodates overflow of electrically insulating liquid encapsulant 116 from each of the semiconductor modules 100. As the volume of electrically insulating liquid encapsulant 116 in the semiconductor modules 100 increases due to thermal expansion, it flows into the centralized expansion 206 unit via the piping 204. The centralized expansion unit 206 is arranged to maintain constant pressure in the semiconductor modules 100 through a thermal differential of the electrically insulating liquid encapsulant 116, e.g., in a similar manner as a heat pump system.

Although the present disclosure is not so limited, the following numbered examples demonstrate one or more aspects of the disclosure.

Example 1. A semiconductor module, comprising: a power electronics carrier comprising a metallization layer disposed on an electrically insulating substrate; a power semiconductor die mounted on the power electronics carrier; a housing that surrounds an interior volume over the power electronics carrier; a volume of electrically insulating encapsulant that fills the interior volume and encapsulates the power semiconductor die; and a pressure compensation element disposed on or within the electrically insulating encapsulant, wherein the electrically insulating encapsulant is a liquid, wherein the semiconductor module forms an impermeable seal that contains the volume of electrically insulating encapsulant; and wherein the pressure compensation element is configured to maintain the electrically insulating encapsulant at a substantially constant pressure during thermal expansion and thermal contraction of the electrically insulating encapsulant.

Example 2. The semiconductor module of example 1, wherein the pressure compensation element comprises an elastic element that is disposed on or within the electrically insulating encapsulant, and wherein the elastic element is configured to maintain the electrically insulating encapsulant at the substantially constant pressure by elastically deforming in response to the thermal expansion and the thermal contraction.

Example 3. The semiconductor module of example 1, wherein the semiconductor module comprises a sealant layer on an upper surface of the encapsulant that is opposite from the power electronics carrier, and wherein the sealant layer forms part of the impermeable seal.

Example 4. The semiconductor module of example 3, wherein the sealant layer comprises an elastic membrane that is disposed on the upper surface of the encapsulant and extends between sidewalls of the housing, and wherein the elastic membrane forms at least part of the pressure compensation element.

Example 5. The semiconductor module of example 4, further comprising a three-dimensional grid of material that is substantially rigid at room temperature and is immersed within the volume of electrically insulating encapsulant.

Example 6. The semiconductor module of example 3, wherein the semiconductor module further comprises a lid that is dimensioned to be arranged on the sidewalls of the housing and enclose the interior volume, and wherein the sealant layer is attached to the lid.

Example 7. The semiconductor module of example 1, wherein the pressure compensation element comprises a sealed bubble that is immersed within the electrically insulating encapsulant, wherein the sealed bubble comprises an elastic membrane and a gaseous volume contained within the elastic membrane, and wherein the sealed bubble maintains the electrically insulating encapsulant at the substantially constant pressure by compressing in response to the thermal expansion and expanding in response to the thermal contraction.

Example 8. The semiconductor module of example 7, further comprising a rigid layer on an upper surface of the electrically insulating encapsulant that is opposite from the power electronics carrier, and wherein the rigid layer forms part of the impermeable seal.

Example 9. The semiconductor module of example 1, wherein the electrically insulating encapsulant is a liquid at temperatures between -40°C and 200°C.

Example 10. The semiconductor module of example 9, wherein the electrically insulating encapsulant is a silicon-based oil.

Example 11. A method of producing a semiconductor module, the method comprising: providing a power electronics carrier comprising a metallization layer disposed on an electrically insulating substrate; mounting a power semiconductor die on the power electronics carrier; providing a housing that surrounds an interior volume over the power electronics carrier; filling the interior volume with a liquid volume of electrically insulating encapsulant that encapsulates the power semiconductor die; forming an impermeable seal around the liquid volume of electrically insulating encapsulant; and providing a pressure compensation element on or within the electrically insulating encapsulant, wherein the pressure compensation element is configured to maintain the electrically insulating encapsulant at a substantially constant pressure during thermal expansion and thermal contraction of the electrically insulating encapsulant.

Example 12. The method of example 11, wherein the pressure compensation element comprises an elastic element that is disposed on or within the electrically insulating encapsulant, and wherein the elastic element is configured to maintain the electrically insulating encapsulant at the substantially constant pressure by elastically deforming in response to the thermal expansion and the thermal contraction.

Example 13. The method of example 11, wherein forming the impermeable seal comprises forming a layer of sealant material on top of the liquid encapsulant after the interior volume is filled with the encapsulant.

Example 14. The method of example 11, wherein forming the impermeable seal comprises providing a lid that comprises a sealant layer attached to the lid and arranging the lid on the housing such that the sealant la contacts the liquid encapsulant

Example 15. The method of example 11, wherein forming the impermeable seal comprises forming a liquid tight seal between the housing and a bottom interface of the housing, wherein the bottom interface of the housing is an interface between the housing and the power electronics carrier or a metal baseplate.

Example 16. An electronics assembly, comprising, a plurality of semiconductor modules, each of the semiconductor modules comprising a power electronics carrier comprising a metallization layer disposed on an electrically insulating substrate, a power semiconductor die mounted on the power electronics carrier, and a liquid volume of electrically insulating encapsulant that encapsulates the power semiconductor die; and a pressure equalization system that is connected to each of the semiconductor modules, wherein the pressure equalization system is configured to equalize a pressure of the electrically insulating encapsulant from each of the semiconductor modules during thermal expansion and thermal contraction of the electrically insulating encapsulant.

Example 17. The electronics assembly of example 16, wherein the pressure equalization system comprises piping that is connected to the interior volume of each of the semiconductor modules and a centralized expansion unit that accommodates overflow of electrically insulating encapsulant from each of the semiconductor modules.

Example 18. The electronics assembly of example 16, wherein the electrically insulating encapsulant is a liquid at temperatures between -40°C and 200°C.

Example 19. The electronics assembly of example 18, wherein the electrically insulating encapsulant is a silicon-based oil.

The semiconductor dies 108 disclosed herein can be formed in a wide variety of device technologies that utilize a wide variety of semiconductor materials. Examples of such materials include, but are not limited to, elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AlGaN), aluminum indium nitride (AllnN), indium gallium nitride (InGaN), aluminum gallium indium nitride (AIGalnN) or indium gallium arsenide phosphide (InGaAsP), etc.

The semiconductor dies 108 disclosed herein may be configured as a vertical device, which refers to a device that conducts a load current between opposite facing main and rear surfaces of the die. Alternatively, the semiconductor dies 108 may be configured as a lateral device, which refers to a device that conducts a load current parallel to a main surface of the die.

Spatially relative terms such as "under," "below," "lower," "over," "upper" and the like, are used for ease of description to explain the positioning of one element relative to a second element. These terms are intended to encompass different orientations of the device in addition to different orientations than those depicted in the figures. Further, terms such as "first," "second," and the like, are also used to describe various elements, regions, sections, etc. and are also not intended to be limiting. Like terms refer to like elements throughout the description.

As used herein, the terms "having," "containing," "including," "comprising" and the like are open-ended terms that indicate the presence of stated elements or features, but do not preclude additional elements or features. The articles "a," "an" and "the" are intended to include the plural as well as the singular, unless the context clearly indicates otherwise.

With the above range of variations and applications in mind, it should be understood that the present invention is not limited by the foregoing description, nor is it limited by the accompanying drawings. Instead, the present invention is limited only by the following claims and their legal equivalents.

## Claims

1. A semiconductor module, comprising:
a power electronics carrier comprising a metallization layer disposed on an electrically insulating substrate;
a power semiconductor die mounted on the power electronics carrier;
a housing that surrounds an interior volume over the power electronics carrier;
a volume of electrically insulating encapsulant that fills the interior volume and encapsulates the power semiconductor die; and
a pressure compensation element disposed on or within the electrically insulating encapsulant,
wherein the electrically insulating encapsulant is a liquid,
wherein the semiconductor module forms an impermeable seal that contains the volume of electrically insulating encapsulant, and
wherein the pressure compensation element is configured to maintain the electrically insulating encapsulant at a substantially constant pressure during thermal expansion and thermal contraction of the electrically insulating encapsulant.

2. The semiconductor module of claim 1, wherein the pressure compensation element comprises an elastic element that is disposed on or within the electrically insulating encapsulant, and wherein the elastic element is configured to maintain the electrically insulating encapsulant at the substantially constant pressure by elastically deforming in response to the thermal expansion and the thermal contraction.

3. The semiconductor module of claim 1 or 2, wherein the semiconductor module comprises a sealant layer on an upper surface of the encapsulant that is opposite from the power electronics carrier, and wherein the sealant layer forms part of the impermeable seal.

4. The semiconductor module of claim 3, wherein the sealant layer comprises an elastic membrane that is disposed on the upper surface of the encapsulant and extends between sidewalls of the housing, and wherein the elastic membrane forms at least part of the pressure compensation element.

5. The semiconductor module of claim 4, further comprising a three-dimensional grid of material that is substantially rigid at room temperature and is immersed within the volume of electrically insulating encapsulant.

6. The semiconductor module of claim 3 or 4, wherein the semiconductor module further comprises a lid that is dimensioned to be arranged on the sidewalls of the housing and enclose the interior volume, and wherein the sealant layer is attached to the lid.

7. The semiconductor module of one of the preceding claims, wherein the pressure compensation element comprises a sealed bubble that is immersed within the electrically insulating encapsulant, wherein the sealed bubble comprises an elastic membrane and a gaseous volume contained within the elastic membrane, and wherein the sealed bubble maintains the electrically insulating encapsulant at the substantially constant pressure by compressing in response to the thermal expansion and expanding in response to the thermal contraction.

8. The semiconductor module of claim 7, further comprising a rigid layer on an upper surface of the electrically insulating encapsulant that is opposite from the power electronics carrier, and wherein the rigid layer forms part of the impermeable seal.

9. The semiconductor module of one of the preceding claims, wherein the electrically insulating encapsulant is a liquid at temperatures between -40°C and 200°C.

10. The semiconductor module of claim 9, wherein the electrically insulating encapsulant is a silicon-based oil.

11. A method of producing a semiconductor module, the method comprising:
providing a power electronics carrier comprising a metallization layer disposed on an electrically insulating substrate;
mounting a power semiconductor die on the power electronics carrier;
providing a housing that surrounds an interior volume over the power electronics carrier;
filling the interior volume with a liquid volume of electrically insulating encapsulant that encapsulates the power semiconductor die;
forming an impermeable seal around the liquid volume of electrically insulating encapsulant; and
providing a pressure compensation element on or within the electrically insulating encapsulant,
wherein the pressure compensation element is configured to maintain the electrically insulating encapsulant at a substantially constant pressure during thermal expansion and thermal contraction of the electrically insulating encapsulant.

12. The method of claim 11, wherein the pressure compensation element comprises an elastic element that is disposed on or within the electrically insulating encapsulant, and wherein the elastic element is configured to maintain the electrically insulating encapsulant at the substantially constant pressure by elastically deforming in response to the thermal expansion and the thermal contraction.

13. The method of claim 11 or 12, wherein forming the impermeable seal comprises forming a layer of sealant material on top of the liquid encapsulant after the interior volume is filled with the encapsulant.

14. The method of one of claims 11 to 13, wherein forming the impermeable seal comprises providing a lid that comprises a sealant layer attached to the lid and arranging the lid on the housing such that the sealant la contacts the liquid encapsulant

15. The method of one of claims 11 to 14, wherein forming the impermeable seal comprises forming a liquid tight seal between the housing and a bottom interface of the housing, wherein the bottom interface of the housing is an interface between the housing and the power electronics carrier or a metal baseplate.
